# EUROPÄISCHE PATENTANMELDUNG

(11) **EP 2 958 149 A1**
(43) Veröffentlichungstag der Anmeldung: **23.12.2015**
(21) Anmeldenummer: 15164423.4
(22) Anmeldetag: 21.04.2015
(51) Int. Cl.: H01L 31/0352, H01L 31/103, H01L 27/146

(54) **THERMODIODENELEMENT FÜR EINEN FOTOSENSOR ZUR INFRAROT-STRAHLUNGSMESSUNG, FOTOSENSOR UND VERFAHREN ZUM HERSTELLEN EINES THERMODIODENELEMENTS**

(30) Priorität: 20.06.2014 DE 102014211829
(71) Anmelder: ROBERT BOSCH GMBH, 70442 Stuttgart (DE)
(72) Erfinder: Herrmann, Ingo, 71292 Friolzheim (DE); Utermoehlen, Fabian, 70197 Stuttgart (DE); Schelling, Christoph, 70597 Stuttgart (DE)

(57) **Zusammenfassung**

Die Erfindung betrifft ein Thermodiodenelement (100) für einen Fotosensor (632) für eine Thermokamera (630) zur Infrarot-Strahlungsmessung. Das Thermodiodenelement (100) weist auf ein Halbleitersubstrat mit einer ersten Schicht (102) und einer an die erste Schicht (102) angrenzenden zweiten Schicht (104), eine Bodendotierungszone (106) in der ersten Schicht (102), eine Seitendotierungszone (108) in der zweiten Schicht (104), wobei die Bodendotierungszone (106) und Seitendotierungszone (108) den gleichen ersten Dotierungstyp aufweisen, und eine weitere Dotierungszone (110) in der zweiten Schicht (104) als Insel in der Seitendotierungszone (108), wobei die Bodendotierungszone (106) an der weiteren Dotierungszone (110) angrenzend angeordnet ist, wobei die weitere Dotierungszone (110) einen zum ersten Dotierungstyp entgegengesetzten zweiten Dotierungstyp aufweist.

## Beschreibung

### Stand der Technik

Die vorliegende Erfindung bezieht sich auf ein Thermodiodenelement für einen Fotosensor für eine Thermokamera zur Infrarot-Strahlungsmessung, auf einen Fotosensor für eine Thermokamera zur Infrarot-Strahlungsmessung sowie auf ein Verfahren zum Herstellen eines Thermodiodenelements für einen Fotosensor für eine Thermokamera zur Infrarot-Strahlungsmessung.

Thermografiekameras zur ortsaufgelösten Temperaturmessung verwenden eine thermisch empfindliche Sensoranordnung, bei der eine Wärmeeigenstrahlung eines Objekts auf eine Anordnung von thermosensitiven Sensorelementen abgebildet wird. Infrarotstrahlung erwärmt die Sensorelemente um Beträge in der Größenordnung von wenigen Millikelvin. Herkömmliche Pixeldesigns erfordern eine in der Herstellung kostenaufwendige Rundumpassivierung des thermosensitiven Elements.

### Offenbarung der Erfindung

Vor diesem Hintergrund werden mit dem hier vorgestellten Ansatz ein verbessertes Thermodiodenelement für einen Fotosensor für eine Thermokamera zur Infrarot-Strahlungsmessung, weiterhin einen verbesserten Fotosensor für eine Thermokamera zur Infrarot-Strahlungsmessung sowie schließlich ein entsprechendes Verfahren zum Herstellen eines Thermodiodenelements für einen Fotosensor für eine Thermokamera zur Infrarot-Strahlungsmessung gemäß den Hauptansprüchen vorgestellt. Vorteilhafte Ausgestaltungen ergeben sich aus den jeweiligen Unteransprüchen und der nachfolgenden Beschreibung.

Ein rauscharmes Thermodiodenelement kann aus einem Halbleitersubstrat geschaffen werden, welches zumindest zwei unterschiedlich dotierte Bereiche aufweist. Dabei ist in einer Wanne eines ersten Dotierungstyps eine weitere Dotierungszone eines dem ersten Dotierungstyp entgegengesetzten Dotierungstyps angeordnet. Dabei kann der hier als Wanne bezeichnete Bereich, insbesondere fertigungstechnisch, zwei Dotierungszonen umfassen.

Es wird ein Thermodiodenelement für einen Fotosensor für eine Thermokamera zur Infrarot-Strahlungsmessung vorgestellt, wobei das Thermodiodenelement die folgenden Merkmale aufweist:
ein Halbleitersubstrat mit einer ersten Schicht und einer an die erste Schicht angrenzenden zweiten Schicht;
eine Bodendotierungszone in der ersten Schicht, wobei die Bodendotierungszone einen ersten Dotierungstyp aufweist;
eine Seitendotierungszone in der zweiten Schicht, wobei die Seitendotierungszone den ersten Dotierungstyp aufweist; und
eine weitere Dotierungszone in der zweiten Schicht als Insel in der Seitendotierungszone, wobei die Bodendotierungszone an der weiteren Dotierungszone angrenzend angeordnet ist, und wobei die weitere Dotierungszone einen zum ersten Dotierungstyp entgegengesetzten zweiten Dotierungstyp aufweist.

Unter einem Thermodiodenelement kann ein Sensorelement oder eine Thermodiode verstanden werden. Das Thermodiodenelement kann auch als Siliziuminsel bezeichnet werden. Bei dem Thermodiodenelement kann es sich um ein mikroelektronisches Bauelement handeln. Das Thermodiodenelement kann zur Erfassung von Infrarotstrahlen verwendet werden. Dabei kann beispielsweise langwellige Infrarotstrahlung erfasst werden, beispielsweise Wellenlängen im Bereich von ca. 8 bis 14 µm. Das Halbleitersubstrat kann als Wafer bezeichnet werden. Die erste Schicht und ergänzend oder alternativ die zweite Schicht des Halbleitersubstrats können als einkristalline Schichten ausgebildet sein. Unter einer Dotierungszone kann ein Bereich des Halbleitersubstrats verstanden werden, der eine bestimmte Dotierung aufweist. Die Bodendotierungszone kann die erste Schicht ausfüllen oder umfassen. Die Bodendotierungszone kann sich über eine Schichtdicke der ersten Schicht erstrecken. Die zweite Schicht kann die Seitendotierungszone und die weitere Dotierungszone umfassen. Die Seitendotierungszone und die weitere Dotierungszone können sich jeweils über eine Schichtdicke der zweiten Schicht erstrecken. Die weitere Dotierungszone kann von der Seitendotierungszone umfasst oder umschlossen sein. Die Bodendotierungszone kann dabei an die Seitendotierungszone und an die weitere Dotierungszone anschließend angeordnet sein. Die Bodendotierungszone und die Seitendotierungszone können zusammen eine Wanne bilden, die die weitere Dotierungszone bis auf eine Seite umschließt. So kann an die weitere Dotierungszone in fünf Raumrichtungen entweder die Bodendotierungszone oder die Seitendotierungszone angrenzen. Der erste Dotierungstyp kann eine p-Dotierung und der zweite Dotierungstyp kann eine n-Dotierung bezeichnen. Alternativ können der erste Dotierungstyp eine n-Dotierung und der zweite Dotierungstyp eine p-Dotierung bezeichnen. Bei einer n-Dotierung kann eine freibewegliche negative Ladung eingebracht werden. Bei einer p-Dotierung kann eine freibewegliche positive Lücke, auch Loch oder Defektelektron genannt, eingebracht werden. Vorteilhaft wird ein rauscharmes, hochsensitives Thermodiodenelement für Thermografieanwendungen, basierend auf dem bolometrischen Prinzip, bereitgestellt.

Die Bodendotierungszone und ergänzend oder alternativ die Seitendotierungszone können eine starke Dotierung aufweisen. Unterschiedliche Dotierungsgrade können als starke Dotierung (n+; p+), mittlere Dotierung (n; p) und schwache Dotierung (n-, p-) unterschieden werden. Durch räumlich benachbarte unterschiedliche Dotierungsbereiche oder Dotierungszonen im Halbleitersubstrat kann beispielsweise ein p-n-Übergang mit einer Raumladungszone gebildet werden. Die starke Dotierung kann beispielsweise einen Dotierungsgrad von mehr als 10¹⁸ Störstellen oder Dotieratome pro cm³ repräsentieren.

Die weitere Dotierungszone kann eine mittlere Dotierung aufweisen. Insbesondere kann eine mittlere Dotierung einen Dotierungsgrad in einem Bereich zwischen 10¹⁵ Störstellen pro cm³ und 10¹⁸ Störstellen pro cm³ repräsentieren.

Günstig ist es auch, wenn das Thermodiodenelement eine Kontaktdotierungszone aufweist, die als Kontaktierungsfläche für einen äußeren Kontakt des Thermodiodenelements innerhalb der weiteren Dotierungszone eingebettet ist. Die Kontaktdotierungszone kann den zweiten Dotierungstyp aufweisen. Die Kontaktdotierungszone kann eine höhere Dotierung als die weitere Dotierungszone aufweisen.

In einer Ausführungsform kann die Kontaktdotierungszone eine starke Dotierung aufweisen.

Die Kontaktdotierungszone kann an einer Oberfläche in einem Toleranzbereich in einem konstanten Abstand zur Seitendotierungszone angeordnet sein. So kann die weitere Dotierungszone zwischen der Kontaktdotierungszone und der Seitendotierungszone in einem Toleranzbereich eine konstante Dicke aufweisen. Die weitere Dotierungszone kann zwischen der Bodendotierungszone und der Kontaktdotierungszone in einem Toleranzbereich die gleiche konstante Dicke aufweisen wie zwischen der Kontaktdotierungszone und der Seitendotierungszone. Der Toleranzbereich kann in einer Ausführungsform 10 Prozent umfassen.

Das Thermodiodenelement kann einen ersten Kontakt und einen zweiten Kontakt aufweisen. Der erste Kontakt kann an der Seitendotierungszone und der zweite Kontakt kann an der weiteren Dotierungszone oder alternativ an der Kontaktdotierungszone angeordnet sein. Ein Kontakt kann beispielsweise als ein Kontaktpad, als eine Leitung oder als eine metallische Zuleitung ausgebildet sein.

Die erste Schicht und die zweite Schicht können zusammen eine Schichtdicke von maximal vier Mikrometern aufweisen. Dabei kann die Schichtdicke der ersten Schicht geringer als die Schichtdicke der zweiten Schicht ausgebildet sein. Die Schichtdicke der zweiten Schicht kann zumindest das Dreifache der Schichtdicke der ersten Schicht betragen.

Es wird ein Fotosensor für eine Thermokamera zur Infrarot-Strahlungsmessung vorgestellt, wobei der Fotosensor ein Feld mit einer Mehrzahl von Thermodiodenelementen nach einer der vorangehenden Ausführungsformen aufweist.

Es wird ein Verfahren zum Herstellen eines Thermodiodenelements für einen Fotosensor für eine Thermokamera zur Infrarot-Strahlungsmessung vorgestellt, wobei das Verfahren die folgenden Schritte umfasst:

### Bereitstellen eines Halbleitersubstrats;

Ausbilden eines Schichtaufbaus mit einer ersten Schicht und einer zweiten Schicht auf dem Halbleitersubstrat, wobei eine Bodendotierungszone mit einem ersten Dotierungstyp in der ersten Schicht und, eine Seitendotierungszone mit dem ersten Dotierungstyp und eine weitere Dotierungszone mit einem zum ersten Dotierungstyp entgegengesetzten zweiten Dotierungstyp in der zweiten Schicht mittels eines Verfahrens der Halbleitertechnologie ausgebildet werden, wobei die weitere Dotierungszone als Insel in der Seitendotierungszone und die Bodendotierungszone angrenzend an die weitere Dotierungszone ausgebildet wird.

Bei dem Verfahren zum Herstellen eines Thermodiodenelements kann der Schritt des Ausbildens einen Schritt des Erstellens der ersten Schicht als eine einkristalline Schicht auf dem Halbleitersubstrat, wobei die erste Schicht die Bodendotierungszone aufweist, einen Schritt des Aufbringens der zweiten Schicht als eine einkristalline Schicht auf der ersten Schicht, wobei die zweite Schicht die weitere Dotierungszone aufweist, und einen Schritt des Einbringens eines Dotierstoffes des ersten Dotierungstyps in einen die weitere Dotierungszone umgebenden Bereich der zweiten Schicht, um die Seitendotierungszone auszubilden, umfassen. Auf diese Weise kann das Thermodiodenelement schichtweise aufgebaut werden.

Das Verfahren zum Herstellen eines Thermodiodenelements kann einen weiteren Schritt des Einbringens eines Dotierstoffes des zweiten Dotierungstyps in die weitere Dotierungszone umfassen. Dadurch kann vorteilhaft eine Kontaktdotierungszone ausgebildet werden.

Das Verfahren zum Herstellen eines Thermodiodenelements kann einen Schritt des Anordnens eines ersten Kontakts an der Seitendotierungszone und eines zweiten Kontakts an der weiteren Dotierungszone oder der Kontaktdotierungszone umfassen. Der erste Kontakt und der zweite Kontakt können als Kontaktpad oder als metallische Zuleitungen ausgebildet sein. Über die Kontakte kann das Thermodiodenelement elektrisch kontaktiert werden.

Das Verfahren zum Herstellen eines Thermodiodenelements kann einen Schritt des Freistellens umfassen, in dem zumindest die Bodendotierungszone, die Seitendotierungszone und die weitere Dotierungszone des Thermodiodenelements freigestellt werden. Beispielsweise kann der Schritt des Freistellens vorteilhaft durch einen Ätzvorgang ausgeführt werden. Im Schritt des Freistellens kann eine Siliziuminsel freigestellt werden, die die Bodendotierungszone, die Seitendotierungszone und die weitere Dotierungszone umfasst.

Der hier vorgestellte Ansatz wird nachstehend anhand der beigefügten Zeichnungen beispielhaft näher erläutert. Es zeigen:
Fig. 1 eine schematische Darstellung eines Thermodiodenelements für einen Fotosensor für eine Thermokamera zur Infrarot-Strahlungsmessung gemäß einem Ausführungsbeispiel der vorliegenden Erfindung;
Fig. 2 ein Schnittbild eines Thermodiodenelements gemäß einem Ausführungsbeispiel der vorliegenden Erfindung;
Fig. 3 ein Schnittbild eines Thermodiodenelements gemäß einem Ausführungsbeispiel der vorliegenden Erfindung;
Fig. 4 ein Schnittbild eines Thermodiodenelements gemäß einem Ausführungsbeispiel der vorliegenden Erfindung;
Fig. 5 ein Schnittbild eines Thermodiodenelements gemäß einem Ausführungsbeispiel der vorliegenden Erfindung;
Fig. 6 eine schematische Darstellung einer Thermokamera mit einem Fotosensor gemäß einem Ausführungsbeispiel der vorliegenden Erfindung;
Fig. 7 ein Ablaufdiagramm eines Verfahrens zum Herstellen eines Thermodiodenelements für einen Fotosensor gemäß einem Ausführungsbeispiel der vorliegenden Erfindung; und
Fig. 8 ein Ablaufdiagramm eines Verfahrens zum Herstellen eines Thermodiodenelements gemäß einem Ausführungsbeispiel der vorliegenden Erfindung.

In der nachfolgenden Beschreibung günstiger Ausführungsbeispiele der vorliegenden Erfindung werden für die in den verschiedenen Figuren dargestellten und ähnlich wirkenden Elemente gleiche oder ähnliche Bezugszeichen verwendet, wobei auf eine wiederholte Beschreibung dieser Elemente verzichtet wird.

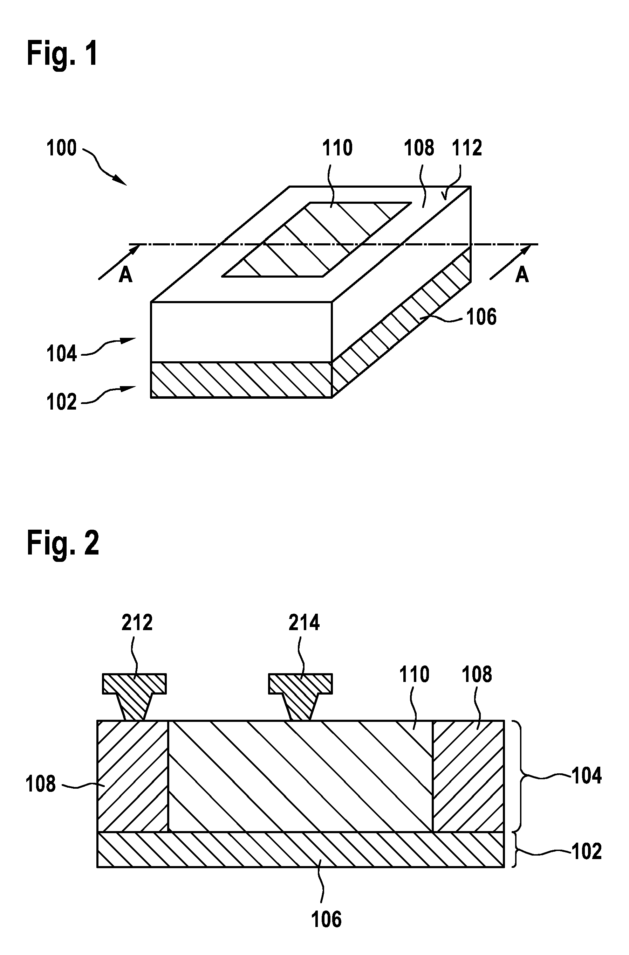

Fig. 1 zeigt eine schematische Darstellung eines Thermodiodenelements 100 für einen Fotosensor für eine Thermokamera zur Infrarot-Strahlungsmessung gemäß einem Ausführungsbeispiel der vorliegenden Erfindung. Das Thermodiodenelement 100 weist ein Halbleitersubstrat mit einer ersten Schicht 102 und einer an die erste Schicht angrenzenden zweiten Schicht 104 auf.

Die erste Schicht 102 umfasst eine Bodendotierungszone 106. Die zweite Schicht 104 umfasst eine Seitendotierungszone 108 und eine weitere Dotierungszone 110. Die Bodendotierungszone 106 sowie die Seitendotierungszone 108 bilden zusammen eine Wanne für die weitere Dotierungszone 110. So grenzt die Seitendotierungszone 108 an einer Seite direkt an die Bodendotierungszone 106. Die weitere Dotierungszone 110 wird von der Seitendotierungszone 108 vollständig umfasst. In Fig. 1 direkt nicht ersichtlich ist, dass die weitere Dotierungszone 110 direkt an die Bodendotierungszone 106 angrenzt. Dies wird in den folgenden Figuren sichtbar, welche Ausführungsbeispiele als Schnittbild entlang der mit A-A gekennzeichneten Schnittebene darstellen.

Die Bodendotierungszone 106 sowie die Seitendotierungszone 108 weisen den gleichen ersten Dotierungstyp auf. Je nach Ausführungsbeispiel handelt es sich bei dem ersten Dotierungstyp um eine p-Dotierung oder alternativ um eine n-Dotierung. Die weitere Dotierungszone 110 weist einen zweiten Dotierungstyp auf, der zum ersten Dotierungstyp entgegengesetzten ist. So weist die weitere Dotierungszone 110 eine n-Dotierung auf, wenn der erste Dotierungstyp eine p-Dotierung aufweist, oder alternativ weist die weitere Dotierungszone 110 eine p-Dotierung auf, wenn die Bodendotierungszone 106 sowie die Seitendotierungszone 108 eine n-Dotierung aufweisen.

In dem in Fig. 1 gezeigten Ausführungsbeispiel weist ein Umriss der weiteren Dotierungszone 110 in einer Aufsicht an der Oberfläche 112 des Thermodiodenelements 100 die Form eines Rechtecks auf. Als Oberfläche 112 wird hierbei die der Bodendotierungszone 106 abgewandte Seite der zweiten Schicht 104 bezeichnet. So kann der genannte Umriss in einem Ausführungsbeispiel die Form eines Quadrats aufweisen. In weiteren nicht gezeigten Ausführungsbeispielen kann der Umriss andere geeignete Formen aufweisen. So sind in einem Ausführungsbeispiel eines Fotosensors eine Vielzahl von Thermodiodenelement beispielsweise wie Bienenwaben angeordnet. Gemäß einem bevorzugten Ausführungsbeispiel weist der Mittenkontakt 214 vom Übergang zwischen der Dotierungszone 110 und der Seitendotierungszone 108 immer denselben Abstand auf. Somit ist ein Kreis eine bevorzugte Ausführungsform.

Fig. 2 zeigt ein Schnittbild eines Thermodiodenelements 100 gemäß einem Ausführungsbeispiel der vorliegenden Erfindung. Bei dem Thermodiodenelement 100 kann es sich um ein Ausführungsbeispiel eines in Fig. 1 gezeigten Thermodiodenelements 100 handeln. Dabei kann die Darstellung einem Schnittbild entlang der in Fig. 1 gezeigten Schnittebene A-A entsprechen. Fig. 2 zeigt einen Querschnitt durch das Thermodiodenelement 100. Das Thermodiodenelement 100 umfasst eine Bodendotierungszone 106, eine weitere Dotierungszone 110 sowie eine Seitendotierungszone 108. In der Darstellung in Fig. 2 ist die Seitendotierungszone 108 rechts und links von der weiteren Dotierungszone 110 angeordnet. Die Bodendotierungszone 106 ist unterhalb anschließend an die weitere Dotierungszone 110 angeordnet. Die Bodendotierungszone 106 bildet eine erste Schicht 102. Die Seitendotierungszone 108 sowie die weitere Dotierungszone 110 bilden eine zweite Schicht 104. Bei der ersten Schicht 102 handelt es sich um eine einkristalline Schicht. Bei der zweiten Schicht 104 handelt es sich um eine weitere einkristalline Schicht.

In dem in Fig. 2 gezeigten Ausführungsbeispiel weist das Thermodiodenelement 100 zwei Kontakte 212, 214 auf. Ein erster Kontakt 212 der zwei Kontakte 212, 214 ist mit der Seitendotierungszone 108 verbunden und an einer Oberfläche der Seitendotierungszone 108 angeordnet. Ein zweiter Kontakt 214 der zwei Kontakte 212, 214 ist mit der weiteren Dotierungszone 110 verbunden und an einer Oberfläche der weiteren Dotierungszone 110 angeordnet. Die den Kontakten 212, 214 gegenüberliegenden Seiten der Dotierungszonen 108, 110 sind in Kontakt mit der Bodendotierungszone 106.

Die Bodendotierungszone sowie die Seitendotierungszone weisen einen ersten Dotierungstyp auf. Die weitere Dotierungszone weist einen zweiten Dotierungstyp auf, wobei sich der zweite Dotierungstyp von dem ersten Dotierungstyp unterscheidet. Bei den zwei Dotierungstypen handelt es sich um eine p-Dotierung und um eine n-Dotierung.

Eine Schichtdicke der zweiten Schicht 104 beträgt bei dem in Fig. 2 dargestellten Ausführungsbeispiel mehr als das Dreifache einer Schichtdicke der ersten Schicht 102. Dabei weisen die erste Schicht 102 und die zweite Schicht 104 zusammen in einem Ausführungsbeispiel eine Schichtdicke von weniger als 4 µm auf.

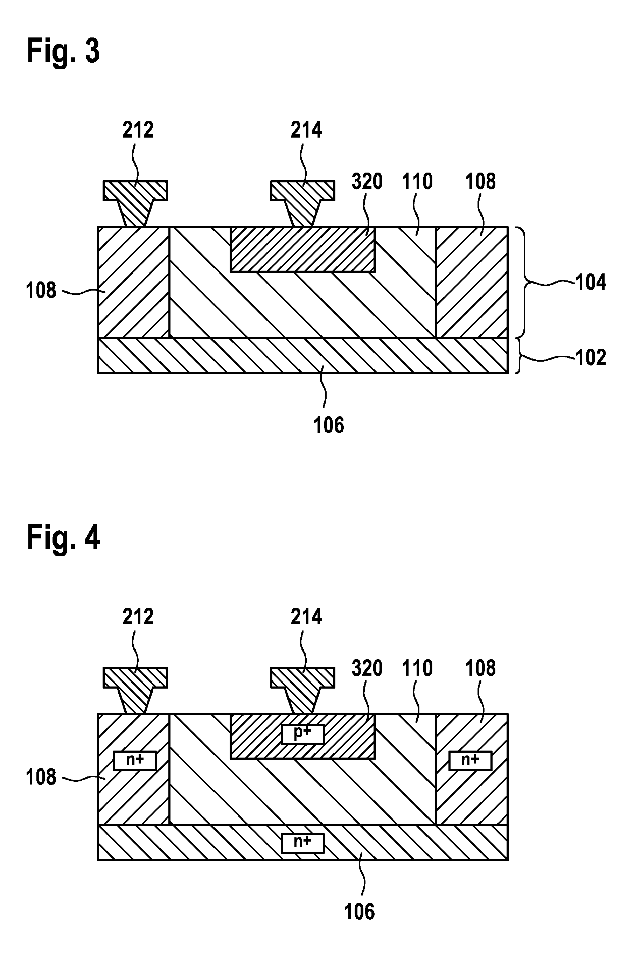

Fig. 3 zeigt ein Schnittbild eines Thermodiodenelements 100 gemäß einem Ausführungsbeispiel der vorliegenden Erfindung. Bei dem Thermodiodenelement 100 kann es sich um ein Ausführungsbeispiel des in Fig. 1 gezeigten Thermodiodenelements 100 handeln. Unter einem Thermodiodenelement 100 kann eine Siliziuminsel 100 verstanden werden. Dabei kann die Darstellung einem Schnittbild entlang der Schnittebene A-A aus Fig. 1 und somit einem Querschnitt durch das Thermodiodenelement 100 entsprechen. Die Darstellung in Fig. 3 entspricht weitgehend der Darstellung in Fig. 2, mit dem Unterschied, dass innerhalb der weiteren Dotierungszone 110 eine Kontaktdotierungszone 320 angeordnet ist. Die Kontaktdotierungszone 320 wird an drei Seiten, in der Darstellung in Fig. 3 links, unten sowie rechts, von der weiteren Dotierungszone 110 umfasst. So bildet die Kontaktdotierungszone 320 eine Kontaktfläche für den zweiten Kontakt 214. Der zweite Kontakt 214 kann als ein äußerer Kontakt 214 bezeichnet werden. So schafft die Kontaktdotierungszone 320 eine Kontaktierungsfläche für einen äußeren Kontakt 214. Der zweite Kontakt 214 steht in Kontakt mit der Kontaktdotierungszone 320.

In dem in Fig. 3 gezeigten Ausführungsbeispiel weist die Kontaktdotierungszone 320 den zweiten Dotierungstyp auf. So weist die Kontaktdotierungszone 320 den gleichen Dotierungstyp auf, wie die weitere Dotierungszone 110. Die Bodendotierungszone 106 und die Seitendotierungszone 108 weisen einen ersten Dotierungstyp auf.

In dem in Fig. 3 gezeigten Ausführungsbeispiel ist die Kontaktdotierungszone 320 an der Oberfläche, das heißt an der der Bodendotierungszone 106 abgewandten Seite, in einem Toleranzbereich in einem konstanten Abstand zur Seitendotierungszone 108 angeordnet.

Das in Fig. 3 dargestellte Thermodiodenelement 100 besteht aus einer freigestellten Siliziuminsel mit mindestens zwei Zuleitungsanschlüssen und mindestens drei Dotierungszonen, wobei je mindestens eine n-Dotierung und eine p-Dotierung enthalten sind. Die Siliziuminsel umfasst zumindest die erste Schicht 102 und die zweite Schicht 104 oder in einer anderen Betrachtungsweise die Bodendotierungszone 106, die Seitendotierungszone 108 sowie die weitere Dotierungszone 110. Die Seitendotierungszone 108 kann als eine erste Dotierungszone 108, die Bodendotierungszone 106 kann als eine zweite Dotierungszone 106 und die weitere Dotierungszone 110 kann auch als eine dritte Dotierungszone 110 bezeichnet werden. Die optionale Kontaktdotierungszone 320 kann als eine vierte Dotierungszone bezeichnet werden. Die Siliziuminsel wird von einer lateral umlaufenden Seitendotierungszone 108 und einer zweiten nach unten begrenzenden Bodendotierungszone 106 gleichen Dotierungstyps (das heißt, n oder p) nach fünf Raumrichtungen begrenzt, die miteinander in Verbindung stehen und eine Wanne bilden. In einem bevorzugten Ausführungsbeispiel sind die zwei Dotierungszonen 106, 108 hochdotiert (> 10¹⁸ Dotieratome/cm³).

Die Siliziuminsel enthält innerhalb der aus der Seitendotierungszone 108 und der Bodendotierungszone 106 gebildeten Wanne eine weitere Dotierungszone 110 entgegengesetzten Dotierungstyps. Dabei ist in einem bevorzugten Ausführungsbeispiel die weitere Dotierungszone 110 geringer dotiert (> 10¹⁵ Störstellen/cm³ jedoch < 10¹⁸ Störstellen/cm³) als die Bodendotierungszone 106 und die Seitendotierungszone 108.

In einem weiteren Ausführungsbeispiel umfasst die Siliziuminsel 100 darüber hinaus optional mittig eine Kontaktdotierungszone 320 mit demselben Dotierungstyp wie die weitere Dotierungszone 110, jedoch mit einer höheren Dotierung (> 10¹⁸ Störstellen/cm³), wobei die Kontaktdotierungszone 320 bevorzugt an einer oben begrenzenden Oberfläche einen konstanten Abstand zur umlaufenden Seitendotierungszone 108 aufweist.

Je nach Ausführungsbeispiel erfolgt die Kontaktierung des Thermodiodenelements 100 über die umlaufende Seitendotierungszone 108 und die weitere Dotierungszone 110 oder die Kontaktdotierungszone 320.

Das in Fig. 3 dargestellte Ausführungsbeispiel eines Thermodiodenelements 100 erfüllt vorteilhaft die Anforderungen an eine rauscharme und temperaturempfindliche Diode für Thermografieanwendungen. Zum einen weist das Thermodiodenelement 100 keine freiliegenden pn-Übergänge an der Oberfläche der freigestellten Siliziuminsel sowie weiterhin einen niedrigen Arbeitspunkt und eine niedrige Stromdichte auf. Diese Anforderungen werden durch eine Dotierungswanne, bestehend aus der Bodendotierungszone 106 und der Seitendotierungszone 108, erfüllt. Dadurch ergibt sich ein in der Tiefe liegender pn-Übergang und, daraus resultierend, ein Stromfluss in der defektarmen Siliziuminsel anstatt an der defektreichen Oberfläche. Dies senkt erheblich das Rauschlevel und erhöht die thermische Sensitivität in Folge der geringeren Stromdichte. Um den Stromfluss homogen zu gestalten und einen ohmschen Kontakt zu realisieren, ist die Wannendotierung in dem in Fig. 3 gezeigten Ausführungsbeispiel hoch dotiert gewählt worden (> 10¹⁸ Störstellen/cm³). Die exakte Position des pn-Überganges kann durch die Dotierung der weiteren Dotierungszone 110, die typischerweise in der Größenordnung zwischen 10¹⁵ Störstellen/cm³ und 10¹⁸ Störstellen/cm³ liegt, eingestellt werden. Der zweite ohmsche Kontakt kann entweder über die weitere Dotierungszone 110 oder über eine höher dotierte Kontaktdotierungszone 320 realisiert werden. Durch eine geeignet hohe Dotierung kann gewährleistet werden, dass ein ohmscher Kontakt anstelle eines Schottkykontaktes hergestellt wird. Sowohl die optionale Kontaktdotierungszone 320 als auch der zugehörige Metallkontakt sind mittig in Bezug zu der umlaufenden lateralen Seitendotierungszone 108 positioniert, um einen homogenen Stromfluss durch das Inselvolumen zu gewährleisten.

Fig. 4 zeigt ein Schnittbild eines Thermodiodenelements 100 gemäß einem Ausführungsbeispiel der vorliegenden Erfindung. Dabei kann die Darstellung einem Schnittbild entlang der Schnittebene A-A entsprechend Fig. 1 beziehungsweise einem Querschnitt durch das Thermodiodenelement 100 entsprechen. Die Darstellung in Fig. 4 entspricht weitgehend der Darstellung in Fig. 3, mit dem Unterschied, dass entsprechende Dotierungsbezeichnungen beziehungsweise entsprechende Dotierungsgrade eingetragen sind. Die Bodendotierungszone 106 sowie die Seitendotierungszone 108 weisen gemäß diesem Ausführungsbeispiel eine starke n-Dotierung (n+) auf. Die weitere Dotierungszone 110 weist eine normale p-Dotierung (p) auf. Die Kontaktdotierungszone 320 weist eine starke p-Dotierung (p+) auf. In diesem Fall wird der erste Kontakt 212 als Katode und der zweite Kontakt 214 als Anode bezeichnet.

In einem Ausführungsbeispiel weisen die Bodendotierungszone 106 sowie die Seitendotierungszone 108 einen ersten Dotierungsgrad n+ auf. So sind die Bodendotierungszone 106 sowie die Seitendotierungszone 108 in einem Ausführungsbeispiel mit mehr als 10¹⁸ Störstellen/cm³ dotiert. In einem bevorzugten Ausführungsbeispiel weisen die Bodendotierungszone 106 sowie die Seitendotierungszone 108 in einem engen Toleranzbereich von weniger als 5 % den gleichen Dotierungsgrad auf.

Die weitere Dotierungszone 110 weist einen zweiten Dotierungsgrad p auf, die Kontaktdotierungszone 320 weist einen dritten Dotierungsgrad p+ auf. Dabei ist in einem bevorzugten Ausführungsbeispiel der dritte Dotierungsgrad größer als der zweite Dotierungsgrad. Bevorzugt liegt der zweite Dotierungsgrad der weiteren Dotierungszone 110 in einem Bereich zwischen 10¹⁵ Störstellen/cm³ und 10¹⁸ Störstellen/cm³.

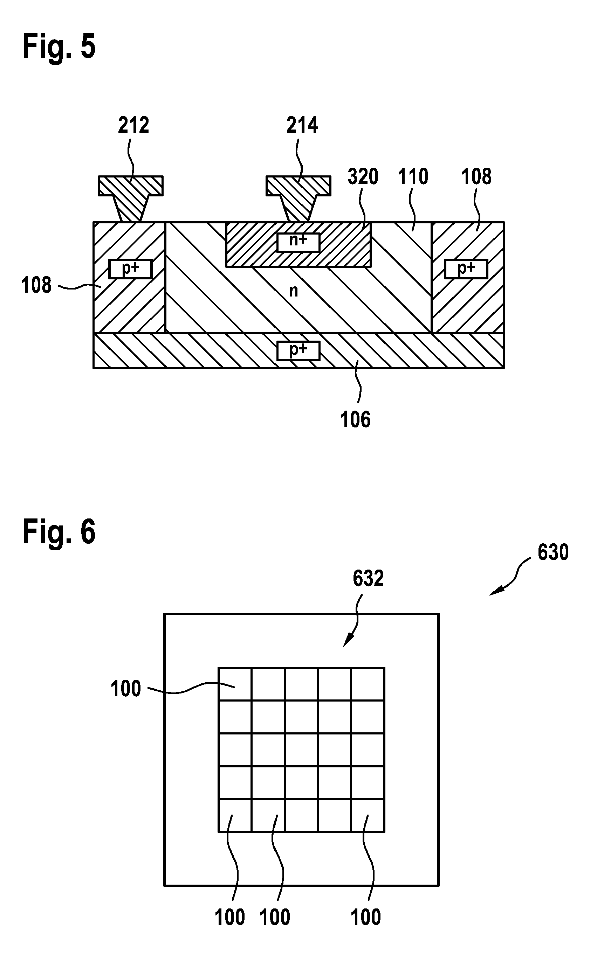

Fig. 5 zeigt ein Schnittbild eines Thermodiodenelements gemäß einem Ausführungsbeispiel der vorliegenden Erfindung. Dabei kann die Darstellung einem Schnittbild entlang der Schnittebene A-A entsprechend Fig. 1 beziehungsweise einem Querschnitt durch ein Thermodiodenelement 100 entsprechen. Die Darstellung in Fig. 5 entspricht weitgehend der Darstellung in Fig. 4, mit dem Unterschied, dass die entsprechenden Dotierungen invertiert sind. Die Bodendotierungszone 106 sowie die Seitendotierungszone 108 weisen eine starke p-Dotierung (p+) auf. Die weitere Dotierungszone 110 weist eine normale n-Dotierung (n) auf. Die Kontaktdotierungszone 320 weist eine starke n-Dotierung (n+) auf. In diesem Fall wird der erste Kontakt 212 als Anode und der zweite Kontakt 214 als Katode bezeichnet.

Analog zur Beschreibung in Fig. 4 gilt, dass in einem Ausführungsbeispiel die Bodendotierungszone 106 sowie die Seitendotierungszone 108 einen ersten Dotierungsgrad n+ aufweisen. So sind die Bodendotierungszone 106 sowie die Seitendotierungszone 108 in einem Ausführungsbeispiel mehr als 10¹⁸ Störstellen/cm³ dotiert. In einem bevorzugten Ausführungsbeispiel weisen die Bodendotierungszone 106 sowie die Seitendotierungszone 108 in einem engen Toleranzbereich von weniger als 5 % den gleichen Dotierungsgrad auf. Die weitere Dotierungszone 110 weist einen zweiten Dotierungsgrad n auf, die Kontaktdotierungszone 320 weist einen dritten Dotierungsgrad n+ auf. Dabei ist in einem bevorzugten Ausführungsbeispiel der dritte Dotierungsgrad größer als der zweite Dotierungsgrad. Bevorzugt liegt der zweite Dotierungsgrad der weiteren Dotierungszone 110 in einem Bereich zwischen 10¹⁵ Störstellen/cm³ und 10¹⁸ Störstellen/cm³. Der dritte Dotierungsgrad kann im Betrag dem ersten Dotierungsgrad entsprechen.

Fig. 6 zeigt eine schematische Darstellung einer Thermokamera 630 mit einem Fotosensor 632 gemäß einem Ausführungsbeispiel der vorliegenden Erfindung. Der Fotosensor 632 umfasst eine Mehrzahl von Thermodiodenelementen 100. Bei den Thermodiodenelementen 100 kann es sich um Ausführungsbeispiele eines in den vorangegangenen Figuren gezeigten Thermodiodenelements 100 handeln. Die Thermodiodenelemente 100 sind in dem gezeigten Ausführungsbeispiel in Zeilen und Spalten in dem Fotosensor 632 angeordnet. Dabei zeigt die Darstellung in Fig. 6 exemplarisch fünf Zeilen und fünf Spalten. Der Übersichtlichkeit halber sind dabei nur vier Thermodiodenelemente 100 mit Bezugszeichen versehen.

In Fig. 6 nicht dargestellt sind weitere Elemente der Thermokamera 630. So umfasst die Thermokamera 630 zumindest eine nicht dargestellte Optik sowie eine nicht dargestellte Auswerteeinrichtung sowie eine Kommunikationsschnittstelle.

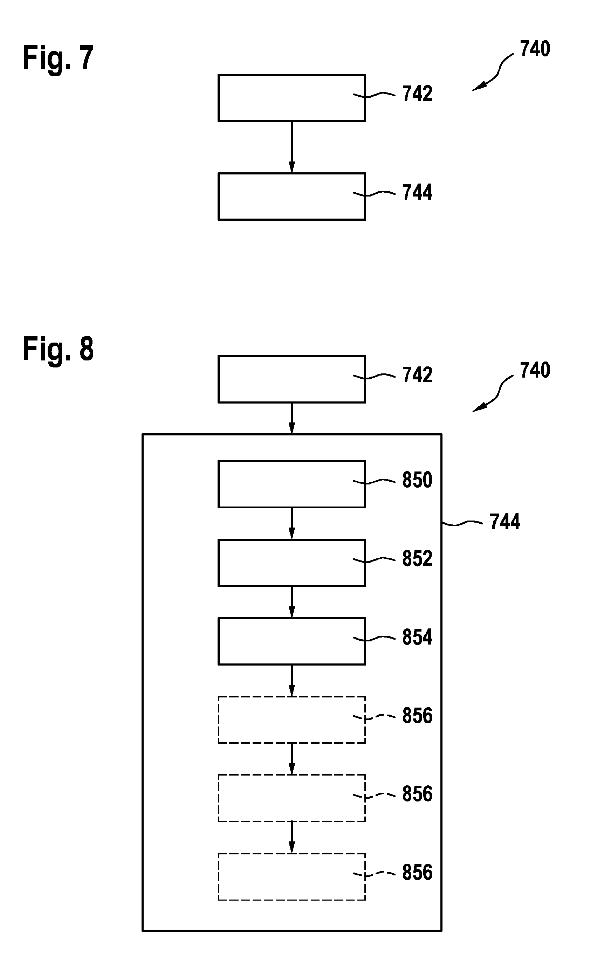

Fig. 7 zeigt ein Ablaufdiagramm eines Verfahrens 740 zum Herstellen eines Thermodiodenelements für einen Fotosensor gemäß einem Ausführungsbeispiel der vorliegenden Erfindung. Bei dem Thermodiodenelement kann es sich um ein Ausführungsbeispiel eines in den vorangegangenen Figuren beschriebenen Thermodiodenelements 100 handeln. Das Verfahren 740 umfasst einen Schritt 742 des Bereitstellens eines Halbleitersubstrats sowie einen Schritt 744 des Ausbildens einer Bodendotierungszone, einer Seitendotierungszone und einer weiteren Dotierungszone. Dabei wird im Schritt 744 des Ausbildens ein Verfahren der Halbleitertechnologie eingesetzt, um eine Variante eines Thermodiodenelements, wie es anhand von Ausführungsbeispielen in den vorangegangenen Figuren beschrieben ist, herzustellen.

Fig. 8 zeigt ein Ablaufdiagramm eines Verfahrens 740 zum Herstellen eines Thermodiodenelements gemäß einem Ausführungsbeispiel der vorliegenden Erfindung. Bei dem Thermodiodenelement kann es sich um ein Ausführungsbeispiel eines in den vorangegangenen Figuren beschriebenen Thermodiodenelements 100 handeln. Bei dem Verfahren 740 handelt es sich um ein Ausführungsbeispiel des in Fig. 7 gezeigten Verfahrens 740 zum Herstellen eines Thermodiodenelements für einen Fotosensor für eine Thermokamera zur Infrarot-Strahlungsmessung. In dem in Fig. 7 beschriebenen Schritt 744 des Ausbildens sind in Fig. 8 eine Mehrzahl von Teilschritten 850, 852, 854, 856, 858, 860 dargestellt.

In einem ersten Teilschritt 850 des Erstellens wird eine erste einkristalline Schicht auf einem Halbleitersubstrat mit einer Bodendotierungszone eines ersten Dotierungstyps erstellt. In einem auf den ersten Teilschritt 850 des Erstellens folgenden zweiten Teilschritt 852 des Abscheidens wird eine zweite einkristalline Schicht auf der ersten Schicht mit einer weiteren Dotierungszone eines zum ersten Dotierungstyp entgegengesetzten zweiten Dotierungstyps abgeschieden. In einem auf den zweiten Teilschritt 852 des Abscheidens folgenden dritten Teilschritt 854 des Einbringens wird ein Dotierstoff des ersten Dotierungstyps eingebracht und derselbe eingetrieben, bis die Seitendotierungszone mit der Bodendotierungszone verbunden ist.

In einem Ausführungsbeispiel weist das Verfahren 740 nach dem Teilschritt 854 des Einbringens einen optionalen weiteren Teilschritt 856 des Einbringens auf, wobei in dem weiteren Teilschritt 856 des Einbringens eine Kontaktdotierungszone des zweiten Dotierungstyps mittig zur Seitendotierungszone eingebracht wird.

In einem Ausführungsbeispiel weist das Verfahren 740 einen Teilschritt 858 des Kontaktierens der Seitendotierungszone mittels eines ersten Kontakts und des Kontaktierens der weiteren Dotierungszone oder alternativ der Kontaktdotierungszone mittels eines zweiten Kontakts auf. Je nach Ausführungsbeispiel sind der erste Kontakt und der zweite Kontakt als Kontaktpad, Leitung oder metallische Zuleitungen ausgebildet.

In einem Ausführungsbeispiel weist das Verfahren 740 einen optionalen Schritt 860 des Freistellens, beispielsweise des Ätzens auf. In dem Schritt 860 des Freistellens wird eine Siliziuminsel freigestellt, wobei die Siliziuminsel zumindest die Bodendotierungszone, die Seitendotierungszone und die weitere Dotierungszone umfasst. Wenn das Thermodiodenelement eine Kontaktdotierungszone aufweist oder der optionale Teilschritt 856 ausgeführt wurde, so umfasst die Siliziuminsel auch die Kontaktdotierungszone.

Das in Fig. 8 dargestellte Verfahren 740 zur Herstellung eines Thermodiodenelements wird im Folgenden anhand eines Ausführungsbeispiels beispielhaft beschrieben. Im Schritt 850 des Erstellens wird eine erste einkristalline Schicht mit einer zweiten Dotierung eines ersten Dotierungstyps auf einem Substrat bereitgestellt. Die erste einkristalline Schicht schafft die Bodendotierungszone. Im Schritt 852 des Abscheidens wird eine zweite einkristallinen Schicht mit einer dritten Dotierung eines zweiten Dotierungstyps auf der ersten Schicht abgeschieden. Im Schritt 854 des Einbringens wird ein Dotierstoff des ersten Dotiertyps eingebracht und der Dotierstoff wird eingetrieben, bis die erste Dotierungszone, das heißt, die Seitendotierungszone, mit der zweiten Dotierungszone, das heißt der Bodendotierungszone, verbunden ist. Die Bodendotierungszone und die Seitendotierungszone bilden zusammen eine Wanne. Im Schritt 854 des Einbringens wird der Dotierstoff in den Randbereichen der zweiten einkristallinen Schicht eingebracht, wobei ein mittig in der zweiten einkristallinen Schicht angeordneter Bereich im Schritt 854 des Einbringens nicht bearbeitet wird. Dieser mittig angeordnete, im Schritt 854 des Einbringens unbearbeitete Bereich bildet die weitere Dotierungszone.

In einem Ausführungsbeispiel wird optional eine vierte Dotierung des zweiten Dotierungstyps mittig zur weiteren Dotierungszone in einem optionalen weiteren Schritt 856 des Einbringens eingebracht. Im weiteren Schritt 856 des Einbringens wird die Kontaktdotierungszone geschaffen. Dabei wird von einer Oberfläche beziehungsweise einer der Bodendotierungszone abgewandten Seite der weiteren Dotierungszone ausgehend dotiert, wobei zwischen der Kontaktdotierungszone und der Bodendotierungszone und zwischen der Kontaktdotierungszone und der Seitendotierungszone die weitere Dotierungszone bestehen bleibt.

In einem Ausführungsbeispiel wird optional im Schritt 858 des Kontaktierens die Seitendotierungszone und die weitere Dotierungszone oder die Kontaktdotierungszone mittels metallischer Zuleitungen kontaktiert.

In einem Ausführungsbeispiel erfolgt optional im Schritt 860 des Ätzens eine Freistellung der Siliziuminsel, das heißt des Thermodiodenelements, durch wenigstens einen Ätzschritt.

Vorteilhaft schafft das beschriebene Verfahren 740 ein rauscharmes Diodendesign mit einem niedrigen Arbeitspunkt und einer hohen Temperatursensitivität.

Die Dotierungen und das Aufwachsen der einzelnen Schichten werden mit Standard-Halbleiterprozessen realisiert. Die zweite einkristalline Schicht wird dabei beispielsweise mit der dritten Dotierung epitaktisch aufgewachsen. Die Gesamtschichtdicke der ersten und zweiten Schicht liegt unter 4µm. Sie ist dadurch bedingt, dass einerseits durch Diffusion eine Verbindung der Bodendotierungszone und der Seitendotierungszone erfolgt und andererseits die Wärmekapazität der Siliziuminsel nicht zu groß wird, um eine hohe Bildwiederholrate erreichen zu können. Die dabei auftretenden Prozesstemperaturen sorgen bereits für eine erste Diffusion der Bodendotierungszone in der ersten Schicht in die zweite Schicht. Die umlaufende Seitendotierungszone wird anschließend mit relativ hohen Dosen (> 10¹⁵ cm⁻²) und Beschleunigungsspannungen (> 200 kV) senkrecht mittels Ionenimplantation eingebracht. Der anschließende Temperaturschritt zum Ausheilen der Schäden in Folge der Implantation sowie zur Ausdiffusion des Dotierstoffes wird derart gewählt, dass eine Verbindung von der ersten Dotierung und der zweiten Dotierung entsteht (> 1000°C). Die optionale vierte Dotierung zum Schaffen der Kontaktdotierungszone erfolgt mit ähnlich hoher Dosis wie die erste Dotierung, allerdings mit kleineren Beschleunigungsspannungen (> 20 kV; jedoch < 50 kV) sowie niedrigerer Eintreibtemperatur < 1000°C).

## Patentansprüche

1. Thermodiodenelement (100) für einen Fotosensor (632) für eine Thermokamera (630) zur Infrarot-Strahlungsmessung, wobei das Thermodiodenelement (100) die folgenden Merkmale aufweist:
ein Halbleitersubstrat mit einer ersten Schicht (102) und einer an die erste Schicht (102) angrenzenden zweiten Schicht (104);
eine Bodendotierungszone (106) in der ersten Schicht (102), wobei die Bodendotierungszone (106) einen ersten Dotierungstyp aufweist;
eine Seitendotierungszone (108) in der zweiten Schicht (104), wobei die Seitendotierungszone (108) den ersten Dotierungstyp aufweist; und
eine weitere Dotierungszone (110) in der zweiten Schicht (104) als Insel in der Seitendotierungszone (108), wobei die Bodendotierungszone (106) an der weiteren Dotierungszone (110) angrenzend angeordnet ist, und wobei die weitere Dotierungszone (110) einen zum ersten Dotierungstyp entgegengesetzten zweiten Dotierungstyp aufweist.

2. Thermodiodenelement (100) gemäß Anspruch 1, bei dem die Bodendotierungszone (106) und/oder die Seitendotierungszone (108) eine starke Dotierung aufweist.

3. Thermodiodenelement (100) gemäß einem der vorangegangenen Ansprüche, bei dem die weitere Dotierungszone (110) eine mittlere Dotierung aufweist.

4. Thermodiodenelement (100) gemäß einem der vorangegangenen Ansprüche, das eine Kontaktdotierungszone (320) aufweist, die als Kontaktierungsfläche für einen äußeren Kontakt (214) des Thermodiodenelements (100) innerhalb der weiteren Dotierungszone (110) eingebettet ist, wobei die Kontaktdotierungszone (320) den zweiten Dotierungstyp aufweist.

5. Thermodiodenelement (100) gemäß Anspruch 4, bei dem die Kontaktdotierungszone (320) eine starke Dotierung aufweist.

6. Thermodiodenelement (100) gemäß einem der vorangegangenen Ansprüche, das einen ersten Kontakt (212) und einen zweiten Kontakt (214) aufweist, wobei der erste Kontakt (212) an der Seitendotierungszone (108) und der zweite Kontakt (214) an der weiteren Dotierungszone (110) oder an der Kontaktdotierungszone (320) angeordnet ist.

7. Thermodiodenelement (100) gemäß einem der vorangegangenen Ansprüche, bei dem die erste Schicht (102) und die zweite Schicht (104) zusammen eine Schichtdicke von maximal vier Mikrometern aufweisen.

8. Fotosensor (632) für eine Thermokamera (630) zur Infrarot-Strahlungsmessung, wobei der Fotosensor (632) ein Feld mit einer Mehrzahl von Thermodiodenelementen (100) nach einem der vorangehenden Ansprüche umfasst.

9. Verfahren (740) zum Herstellen eines Thermodiodenelements (100) für einen Fotosensor (632) für eine Thermokamera (630) zur Infrarot-Strahlungsmessung, wobei das Verfahren (740) die folgenden Schritte umfasst:
Bereitstellen (742) eines Halbleitersubstrats;
Ausbilden (744) eines Schichtaufbaus mit einer ersten Schicht (102) und einer zweiten Schicht (104) auf dem Halbleitersubstrat, wobei eine Bodendotierungszone (106) mit einem ersten Dotierungstyp in der ersten Schicht (102) und eine Seitendotierungszone (108) mit dem ersten Dotierungstyp und eine weitere Dotierungszone (110) mit einem zum ersten Dotierungstyp entgegengesetzten zweiten Dotierungstyp in der zweiten Schicht (104) mittels eines Verfahrens der Halbleitertechnologie ausgebildet werden, wobei die weitere Dotierungszone (110) als Insel in der Seitendotierungszone (108) und die Bodendotierungszone (106) angrenzend an die weitere Dotierungszone (110) ausgebildet wird.

10. Verfahren (740) gemäß Anspruch 9, wobei der Schritt (744) des Ausbildens die folgenden Schritte umfasst:
Erstellen (850) der ersten Schicht (102) als eine einkristalline Schicht auf dem Halbleitersubstrat, wobei die erste Schicht (102) die Bodendotierungszone (106) aufweist;
Aufbringen (852) der zweiten Schicht (104) als eine einkristalline Schicht auf der ersten Schicht (102), wobei die zweite Schicht (104) die weitere Dotierungszone (110) aufweist;
Einbringen (854) eines Dotierstoffes des ersten Dotierungstyps in einen die weitere Dotierungszone (110) umgebenden Bereich der zweiten Schicht (102), um die Seitendotierungszone (108) auszubilden.

11. Verfahren (740) gemäß Anspruch 10, mit einem weiteren Schritt (856) des Einbringens eines Dotierstoffes des zweiten Dotierungstyps in die weitere Dotierungszone (110), um eine Kontaktdotierungszone (320) auszubilden.

12. Verfahren (740) gemäß einem der Ansprüche 9 bis 11, mit einem Schritt (858) des Anordnens eines ersten Kontakts (212) an der Seitendotierungszone (108) und eines zweiten Kontakts (214) an der weiteren Dotierungszone (110) oder der Kontaktdotierungszone (320).

13. Verfahren (740) gemäß einem der Ansprüche 9 bis 12, mit einem Schritt (860) des Freistellens, in dem zumindest die Bodendotierungszone (106), die Seitendotierungszone (108) und die weitere Dotierungszone (110) des Thermodiodenelements (100) freigestellt werden.
